# EUROPÄISCHE PATENTSCHRIFT

(11) **EP 2 729 594 B1**
(45) Veröffentlichungstag und Bekanntmachung des Hinweises auf die Patenterteilung: **04.11.2015**
(21) Anmeldenummer: 12746037.6
(22) Anmeldetag: 09.07.2012
(51) Int. Cl.: C23C 16/44, C23C 16/54, C23C 16/458, H01L 31/18

(54) **VERFAHREN UND VORRICHTUNG ZUR KONTINUIERLICHEN BESCHICHTUNG VON SUBSTRATEN**
METHOD AND DEVICE FOR CONTINUOUSLY COATING SUBSTRATES
PROCÉDÉ ET DISPOSITIF DE REVÊTEMENT DE SUBSTRATS EN CONTINU

(30) Priorität: 07.07.2011 DE 102011106859
(43) Veröffentlichungstag der Anmeldung: 14.05.2014
(73) Patentinhaber: Fraunhofer Gesellschaft zur Förderung der angewandten Forschung E.V., 80686 München (DE)
(72) Erfinder: REBER, Stefan, 79194 Gundelfingen (DE); SCHILLINGER, Norbert, 79241Ihringen (DE); POCZA, David, 79117 Freiburg (DE); ARNOLD, Martin, 79194 Gundelfingen (DE)
(86) Internationale Anmeldenummer: PCT/EP2012/063425
(87) Internationale Veröffentlichungsnummer: WO 2013/004851

(56) Entgegenhaltungen:
- DE-B3-102005 045 582
- S. REBER ET AL: "CONCVD AND PROCONCVD: DEVELOPMENT OF HIGH-THROUGHPUT CVD TOOLS ON THE WAY TO LOW-COST SILICON EPITAXY", EUROPEAN PHOTOVOLTAIC SOLAR ENERGY CONFERENCE AND EXHIBITION (EU PVSEC), 1. Januar 2009 (2009-01-01), Seiten 2560-2564, XP55040628, München DOI: 10.4229/24thEUPVSEC2009-3AV.1.27 ISBN: 978-3-93-633825-6 in der Anmeldung erwähnt

## Beschreibung

Die Erfindung betrifft ein Verfahren zur kontinuierlichen Beschichtung von Substraten, bei dem die Substrate kontinuierlich durch einen Abscheideraum transportiert werden und gleichzeitig Maßnahmen ergriffen werden, um parasitäre Abscheidungen so gut wie möglich zu reduzieren. Ebenso betrifft die Erfindung eine entsprechende Vorrichtung für die kontinuierliche Beschichtung von Substraten.

Für die Konzipierung von Beschichtungsanlagen ist es nach wie vor ein wesentlicher Aspekt, kontinuierliche Edukt- und Produktströme zu erzeugen. Allerdings können bei aus dem Stand der Technik bekannten Beschichtungsanlagen für die kontinuierliche Beschichtung unerwünschte Begleiterscheinungen beim Abscheideprozess auftreten. Hierzu zählen:
- Die Geometrie des Abscheideraums kann verändert werden, und damit die Gasströmungen. Dies wirkt sich bei einigen Abscheidebedingungen auf die Schichthomogenität und die Schichtqualität aus.
- Transportwege können durch parasitäre Schichten oder Partikel blockiert werden, oder Reibung kann erhöht werden, was bis zur Blockade eines Trägertransports führen kann.
- Gaswege können blockiert werden, was zu Gasaustritt und damit bedingt gefährlichen Situationen führen kann.
- Parasitäre Schichten können abblättern, was zu Partikelbildung in der Abscheidekammer und damit zu "schlechten" Schichten, eventuell bis hin zum wirtschaftlichen Totalverlust der Schicht führt.
- Die Uptime der Anlage wird verschlechtert, weil die Abscheidungen oft zurückgeätzt werden können.

Für die hier aufgeführten Probleme wurden bislang unterschiedliche Lösungskonzepte vorgeschlagen (S. Reber et al., CONCVD and PROCONCVD: Development of High-Throughput CVD Tools on the Way to Low-Cost Silicon Epitaxy, 24th European PV Solar Energy Conference and Exhibition, Hamburg und A. Hurrle et al., High-Throughput Continuous CVD Reactor for Silicon Deposition, 19th European Photovoltaic Solar Energy Conference, 2004).

Hierzu zählt das regelmäßige Reinigen durch in-situ-Rückätzen der parasitären Schichten. Allerdings kann dieses Verfahren bei einigen Schichten, z.B. Siliziumcarbid, nicht angewendet werden, da diese Schichten ätzresistent sind.

Ein anderer Ansatz zur Beseitigung parasitärer Abscheidungen basiert auf dem regelmäßigen ex-situ-Reinigen. Dies ist allerdings mit einem zusätzlichen Zeitaufwand verbunden.

Weiterhin können parasitäre Abscheidungen dadurch entfernt werden, dass ein regelmäßiges Austauschen der parasitär beschichteten Flächen erfolgt. Dies stellt aber eine kostspielige Variante dar.

Ein anderer Ansatz basiert darauf, dass "wertvolle" Flächen vor parasitären Abscheidungen mittels eines Abdeckmaterials geschützt werden. Dieses Abdeckmaterial kann entweder ex-situ gereinigt oder ausgetauscht werden.

Weiterhin ist es bekannt, die angesprochenen Probleme dadurch zu lösen, dass der Kontakt der Flächen mit Prozessgas durch gerichtete Gasströmung, z.B. Gasvorhänge, Gaspolster, etc., vermieden wird. Diese Variante kann jedoch auch nur bedingt die Entstehung parasitärer Abscheidungen verhindern.

Ausgehend hiervon war es Aufgabe der vorliegenden Erfindung, ein Verfahren und eine Vorrichtung zur kontinuierlichen Beschichtung bereitzustellen, mit dem die parasitären Abscheidungen minimiert werden, so dass der Zyklus zur Entfernung parasitärer Abscheidungen deutlich verringert werden kann.

Diese Aufgabe wird durch das Verfahren zur kontinuierlichen Beschichtung von Substraten mit den Merkmalen des Anspruchs 1 und die entsprechende Vorrichtung mit den Merkmalen des Anspruchs 8 gelöst. Die weiteren abhängigen Ansprüche zeigen vorteilhafte Weiterbildungen auf.

Das Prinzip der vorliegenden Erfindung basiert darauf, dass die Substratträger für das zu beschichtende Werkstück so ausgebildet werden, dass möglichst viele der parasitären Flächen mit dem Substratträger temporär verbunden sind und mit dem Transport des Werkstücks aus der Anlage transportiert werden.

Erfindungsgemäß wird somit ein Verfahren zur kontinuierlichen Beschichtung von Substraten bereitgestellt, bei dem in einer Beschichtungsvorrichtung die Substrate durch einen Abscheideraum, der durch zwei Substratträger sowie einen Boden und einen Deckel begrenzt ist, wobei der Boden eine Vorrichtung zur Führung der Substratträger aufweist, die Substrate auf den Substratträgern durch die Beschichtungsvorrichtung transportiert werden, während des Transports die kontinuierliche Beschichtung der Substrate erfolgt und wobei der Deckel an den Substratträgern fixiert ist und so zusammen mit den Substratträgern durch die Beschichtungsvorrichtung transportiert wird.

Unter einer Fixierung zwischen Deckel und Substratträger ist hier zu verstehen, dass diese Bauteile beim Transport durch die Beschichtungsvorrichtung eine feste Verbindung aufweisen, d.h das eine gegenseitige Verschiebung von Deckel zu Substratträgern verhindert wird. Dies kann insbesondere durch eine kraftschlüssige Verbindung realisiert werden. Im Unterschied zu einer Verbindugn, die ein Verschieben zwischen Deckel und Substratträger erlaubt, wie es aus dem Stand der Technik bekannt ist, liegt hier der erfindungsgemäße Vorteil, dass zum einen die Reibung zwischen den Bauteilen (und dem damit verbundenen Nachteil der bildung Abriebspartikeln) verhindert werden kann und zum andern eine deutliche effektivere Abdichtung des Abscheidraums ermöglicht wird.

Bei der Fixierung von Deckel und Substratträger ist eine lösbare Verbindung bvevorzugt. Hierdurch kann der Deckel ausserhalb des Abscheidraums von den Substratträgern getrennt und z.B. gesondert von den Substratträgern gereinigt werden.

Die wichtigsten Vorteile des erfindungsgemäßen Verfahren sollen nochmals kurz zusammengefasst werden:
- Aufgrund der Fixierung der Substratträger mit einem Deckel tritt keine Reibung zwischen diesen Bauteilen auf, wodurch verhindert wird, dass durch Reibung zwischen den Schienen und den Substratträgern entstehende Partikel, die in den Abscheideraum eintreten können und dort die Qualität der Abscheidung vermindern, vermieden werden
- Durch die erfindungsgemäße Fixierung der Substratträger mit einem Deckel wird eine deutlich verbesserte Abdichtung der Bauteile erzielt, die bei Verwendung von Schienen für die Substratträger nicht möglich ist
- Da der Deckel im Vergleich zu einer Platte mit Führungsschienen von der Dimensionierung deutlich kleiner ist, kann eine bessere Maßhaltigkeit für das Bauteil sichergestellt werden

Erfindungsgemäß ist eine Zone für die Substrate bevorzugt, in der der Deckel und die Substratträger, die neben dem Boden den Abscheideraum begrenzen gereinigt oder zur Reinigung entnommen werden kann. Im ersten Fall handelt es sich hierbei um eine Reinigungszone, im zweiten Fall um eine Entnahmezone, womit eine in-situ-Reinigung bzw. eine ex-situ-Reinigung ermöglicht wird.

Eine erfindungsgemäße Ausführungsform sieht vor, dass eine Wandung als Deckel ausgeführt ist, der an den Substratträgern fixiert ist und so zusammen mit den Substratträgern aus dem Abscheideraum heraus transportiert wird und anschließend die parasitären Abscheidungen auf diesem Deckel entfernt werden. Im Anschluss kann der Deckel dann bei einem weiteren Beschichtungszyklus wieder eingesetzt werden.

Es ist weiter bevorzugt, dass vor dem Boden (2) im Abscheideraum (4) mindestens ein Abdeckelement (8) angeordnet wird.

Eine weitere erfindungsgemäße Ausführungsform sieht vor, dass als Abdeckelement eine Opferschicht auf mindestens einem der den Abscheideraum begrenzenden Elemente abgeschieden ist. Diese Opferschicht dient dazu, ein späteres Rückätzen zu erleichtern bzw. zu vereinfachen. Die Opferschicht kann auch von den den Abscheideraum begrenzenden Elementen entfernt werden. Die Entfernung einer derartigen Opferschicht ist sowohl in der Beschichtungsvorrichtung als auch außerhalb der Beschichtungsvorrichtung möglich.

Die Opferschicht ist so gestaltet, dass ein Rückätzen parasitärer Abscheidungen maßgeblich vereinfacht wird. Diese Vereinfachung kann z.B. darin bestehen, die Haftfähigkeit parasitärer Abscheidungen herabzusetzen (Trennschicht), mechanische Eigenschaften des Trägermaterials nicht zu verändern (Materialverzug) oder das Eindringen parasitärer Abscheidungen in poröse Materialien zu unterbinden.

Die Opferschicht kann beispielsweise eine Kohlenstoffschicht, insbesondere eine Rußschicht, oder eine Pulverschicht, insbesondere aus Siliciumdioxid oder Siliciumnitrid, sein.

Eine weitere erfindungsgemäße Variante sieht vor, dass als Abdeckelement Lappen, Folien, Lamellen, Kämme, Dichtlippen oder O-Ringe verwendet werden.

Es ist weiter bevorzugt, dass in einer Rückätzzone innerhalb der Beschichtungsanlage parasitäre Abscheidungen mittels Ätzen von den den Abscheideraum begrenzenden Elementen (mindestens einem) und von den zuvor beschriebenen Abdeckelementen entfernt werden.

Die Rückätzzone kann dabei vor, in oder nach dem Abscheideraum angeordnet sein.

Vorzugsweise wird in der Rückätzzone durch mindestens eine Düse ein Ätzmittel geführt und auf mindestens eines der den Abscheideraum begrenzenden Elemente und/oder mindestens eines der vor mindestens einem der begrenzenden Elemente im Abscheideraum angeordneten Abdeckelemente zum Ätzen von parasitären Abscheidungen auf diesen Elementen gerichtet.

Erfindungsgemäß wird ebenso eine Vorrichtung zur kontinuierlichen Beschichtung von Substraten mit einem für die Gasphasenabscheidung vorgesehenen Abscheideraum bereitgestellt, wobei der Abscheideraum durch zwei Substratträger sowie einen Boden und einen Deckel begrenzt ist. Der Boden weist dabei eine Vorrichtung zur Führung der Substratträger auf. Der Deckel ist an den Substratträgern fixiert ist und so zusammen mit den Substratträgern (1,1') durch die Beschichtungsvorrichtung transportabel ist, so dass der Deckel (6) und die Substratträger (1,1') zusammen mit dem Substrat aus dem Abscheideraum (4) heraus transportiert werden können. Die Substrate auf den Substratträgern können dabei durch die Beschichtungsvorrichtung transportiert werden und während des Transports erfolgt die kontinuierliche Beschichtung der Substrate.

Vorzugsweise ist die Vorrichtung zur Führung der Substratträger mindestens eine Schiene.

Die Erfindung weist dabei folgende Vorteile auf, die zur Lösung der zuvor genannten Problematik führen:
- Durch die sofortige Entfernung der parasitären Abscheidung nach jedem Beschichtungszyklus finden Geometrieänderungen der Abscheidekammer nur in unrelevantem Maßstab statt.
- Blockade oder Erschwerung des Probentransports wird minimiert, da Partikel typischerweise nur für dicke Schichten entstehen, d.h. vermieden werden.
- Es können sich keine dicken Schichten aufbauen, die Gaswege blockieren.
- Durch die Vermeidung des Abblätterns ist die Gefahr für schlechte Schichten minimiert.
- Durch die kontinuierliche ex-situ-Reinigung kann die Anlage ohne Unterbrechung im Idealfall gänzlich ohne Reinigungszyklen arbeiten, d.h. die Uptime wird stark erhöht.

Die vorliegende Erfindung findet Anwendung bei Anlagen und Apparaten, insbesondere Beschichtungsanlagen, in denen parasitäre Abscheidungen auftreten und die einen kontinuierlichen Vorschub aufweisen.

Die vorliegende Erfindung umfasst auch die folgenden Aspekte:
1. Verfahren zur kontinuierlichen Beschichtung von Substraten, bei dem die Substrate durch einen Abscheideraum (4), der durch zwei Substratträger (1, 1') sowie zwei Wandungen (2, 2'), von denen zumindest eine Wandung (2, 2') eine Vorrichtung (3, 3') zur Führung der Substratträger (1, 1') aufweist, begrenzt ist, die Substrate auf den Substratträgern (1, 1') durch den Abscheideraum transportiert werden und während des Transports die kontinuierliche Beschichtung der Substrate erfolgt,
   dadurch gekennzeichnet, dass zumindest eines der den Abscheideraum (4) begrenzenden Elemente (1, 1', 2, 2') und/oder mindestens eines der vor mindestens einem der begrenzenden Elemente (1, 1', 2, 2') im Abscheideraum (4) angeordneten Abdeckelemente (8, 8'), die die begrenzenden Elemente (1, 1', 2, 2') vor parasitären Abscheidungen schützen, zusammen mit dem Substrat aus dem Abscheideraum (4) heraus transportiert wird.
2. Verfahren nach Aspekt 1,
   dadurch gekennzeichnet, dass die Vorrichtung eine Zone für die Substrate aufweist, in der mindestens eines der den Abscheideraum (4) begrenzenden Elemente (1, 1', 2, 2') und/oder mindestens eines der vor mindestens einem der begrenzenden Elemente (1,1',2,2') im Abscheideraum (4) angeordneten Abdeckelemente (8, 8') gereinigt oder zur Reinigung entnommen werden kann.
3. Verfahren nach einem der vorhergehenden Aspekte,
   dadurch gekennzeichnet, dass eine Wandung als Deckel (6) ausgeführt ist, der an den Substratträgern (1, 1') fixiert ist und so zusammen mit den Substratträgern (1, 1') aus dem Abscheideraum (4) heraus transportiert wird und anschließend die parasitären Abscheidungen auf dem Deckel (6) entfernt werden.
4. Verfahren nach einem der vorhergehenden Aspekte,
   dadurch gekennzeichnet, dass als Abdeckelement (8, 8') eine Opferschicht auf mindestens einem der den Abscheideraum (4) begrenzenden Elemente (1, 1', 2, 2') abgeschieden ist.
5. Verfahren nach dem vorhergehenden Aspekte,
   dadurch gekennzeichnet, dass die Opferschicht eine Kohlenstoffschicht, insbesondere eine Rußschicht, oder eine Pulverschicht, insbesondere aus Siliciumdioxid oder Siliciumnitrid, ist.
6. Verfahren nach einem der vorhergehenden Aspekte,
   dadurch gekennzeichnet, dass als Abdeckelement (8, 8') Lappen, Folien, Lamellen, Kämme, Dichtlippen oder O-Ringe verwendet werden.
7. Verfahren nach einem der vorhergehenden Aspekte,
   dadurch gekennzeichnet, dass in einer Rückätzzone von mindestens einem der den Abscheideraum (4) begrenzenden Elemente (1, 1', 2, 2') und/oder mindestens eines der vor mindestens einem der begrenzenden Elemente (1,1',2,2') im Abscheideraum (4) angeordneten Abdeckelemente (8, 8') mittels Ätzen die parasitären Abscheidungen entfernt werden.
8. Verfahren nach dem vorhergehenden Aspekte,
   dadurch gekennzeichnet, dass die Rückätzzone vor, nach oder in dem Abscheideraum (4) angeordnet ist.
9. Verfahren nach einem der Aspekte 6 oder 7,
   dadurch gekennzeichnet, dass in der Rückätzzone durch mindestens eine Düse ein Ätzmittel geführt und auf mindestens eines der den Abscheideraum (4) begrenzenden Elemente (1, 1', 2, 2') und/oder mindestens eines der vor mindestens einem der begrenzenden Elemente (1,1',2,2') im Abscheideraum (4) angeordneten Abdeckelemente (8, 8') zum Ätzen von parasitären Abscheidungen auf diesen Elementen gerichtet wird.
10. Vorrichtung zur kontinuierlichen Beschichtung von Substraten mit einem für die Gasphasenabscheidung vorgesehenen Abscheideraum (4), der durch zwei Substratträger (1, 1') sowie zwei Wandungen (2, 2'), von denen zumindest eine Wandung (2, 2') eine Vorrichtung (3,3') zur Führung der Substratträger (1, 1') aufweist, begrenzt ist,
   dadurch gekennzeichnet, dass zumindest eines der den Abscheideraum (4) begrenzenden Elemente (1, 1', 2, 2') und/oder mindestens eines der vor mindestens einem der begrenzenden Elemente (1, 1', 2, 2') im Abscheideraum (4) angeordneten Abdeckelement (8, 8'), die die begrenzenden Elemente (1, 1', 2, 2') vor parasitären Abscheidungen schützen, transportabel ist, dass es zusammen mit dem Substrat aus dem Abscheideraum (4) heraus transportiert werden kann.
11. Vorrichtung nach dem vorhergehenden Aspekt,
   dadurch gekennzeichnet, dass die Vorrichtung eine Zone für die Substrate aufweist, in der mindestens eines der den Abscheideraum (4) begrenzenden Elemente (1, 1', 2, 2') und/oder mindestens eines der vor mindestens einem der begrenzenden Elemente (1, 1', 2, 2') im Abscheideraum (4) angeordneten Abdeckelemente (8, 8') gereinigt oder zur Reinigung entnommen werden kann.
12. Vorrichtung nach einem der Aspekte 10 oder 11,
   dadurch gekennzeichnet, dass eine Wandung als Deckel (6) ausgeführt ist, der für den gemeinsamen Transport mit den Substratträgern (1, 1') aus dem Abscheideraum (4) an den Substratträgern (1, 1') fixiert ist.
13. Vorrichtung nach einem der Aspekte 10 bis 12,
   dadurch gekennzeichnet, dass das Abdeckelement (8, 8') eine Opferschicht ist.
14. Vorrichtung nach dem vorhergehenden Aspekt,
   dadurch gekennzeichnet, dass die Opferschicht eine Kohlenstoffschicht, insbesondere eine Rußschicht, oder eine Pulverschicht, insbesondere aus Siliciumdioxid oder Siliciumnitrid, ist.
15. Vorrichtung nach einem der Aspekte 10 bis 14,
   dadurch gekennzeichnet, dass das Abdeckelement (8,8') ausgewählt ist aus der Gruppe bestehend aus Lappen, Folien, Lamellen, Kämmen, Dichtlippen oder O-Ringen und Kombinationen hiervon.
16. Vorrichtung nach einem der Aspekte 10 bis 15,
   dadurch gekennzeichnet, dass die Vorrichtung eine Rückätzzone aufweist, in der von mindestens einem der den Abscheideraum (4) begrenzenden Elemente (1, 1', 2, 2') und/oder von mindestens einem der vor mindestens einem der begrenzenden Elemente (1, 1', 2, 2') im Abscheideraum (4) angeordneten Abdeckelemente (8, 8') mittels Ätzen die parasitären Abscheidungen entfernt werden.
17. Vorrichtung nach dem vorhergehenden Aspekte,
   dadurch gekennzeichnet, dass die Rückätzzone vor, nach oder in dem Abscheideraum (4) angeordnet ist.
18. Vorrichtung nach einem der Aspekte 16 oder 17,
   dadurch gekennzeichnet, dass in der Rückätzzone mindestens eine Düse für ein Ätzmittel angeordnet ist, wobei die Düse auf mindestens eines der den Abscheideraum (4) begrenzenden Elemente (1, 1', 2, 2') und/oder mindestens eines der vor mindestens einem der begrenzenden Elemente (1, 1', 2, 2') im Abscheideraum (4) angeordneten Abdeckelemente (8, 8') zum Ätzen von parasitären Abscheidungen auf diesen Elementen gerichtet ist.
19. Vorrichtung nach einem der Aspekte 10 bis 18,
   dadurch gekennzeichnet, dass die Vorrichtungen (3, 3') zur Führung der Substratträger (1, 1') Schienen sind.

Anhand der nachfolgenden Figuren soll der erfindungsgemäße Gegenstand näher erläutert werden, ohne diesen auf die hier gezeigten speziellen Ausführungsformen einschränken zu wollen.
Fig. 1 zeigt eine aus dem Stand der Technik bekannte Ausführungsform einer Abscheideanlage.
Fig. 2 zeigt anhand einer schematischen Darstellung eine erste Variante einer erfindungsgemäßen Vorrichtung.
Fig. 3 zeigt anhand einer schematischen Darstellung eine weitere Variante einer erfindungsgemäßen Vorrichtung.
Fig. 4 zeigt anhand einer schematischen Darstellung eine Variante der erfindungsgemäßen Vorrichtung.
Fig. 5 zeigt eine Schnittdarstellung der erfindungsgemäßen Vorrichtung gemäß Fig. 4.

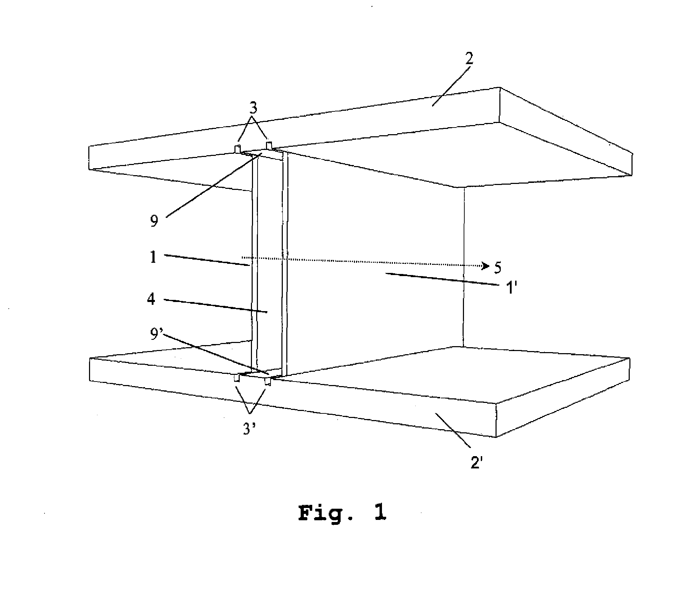

In Fig. 1 ist eine Anordnung dargestellt, bei der zwei Substratträger 1 und 1' parallel angeordnet sind. Diese beiden Substratträger werden entlang einer oberen Schiene 3 und einer unteren Schiene 3' transportiert. Die Prozessgase werden in gebildeten inneren Hohlraum 4 geleitet, wo der Abscheideprozess stattfindet. Die beiden Schienen 3 und 3' sind fest montiert, es findet eine parasitäre Abscheidung an der Decke des Reaktionsraums 9 und dem Boden Reaktionsraumes 9' statt. Zudem entstehen durch Reibung zwischen den Schienen 3 und 3' und den Substratträgern 1 und 1' Partikel, die in den Abscheideraum 4 eintreten können und dort die Qualität der Abscheidung vermindern.

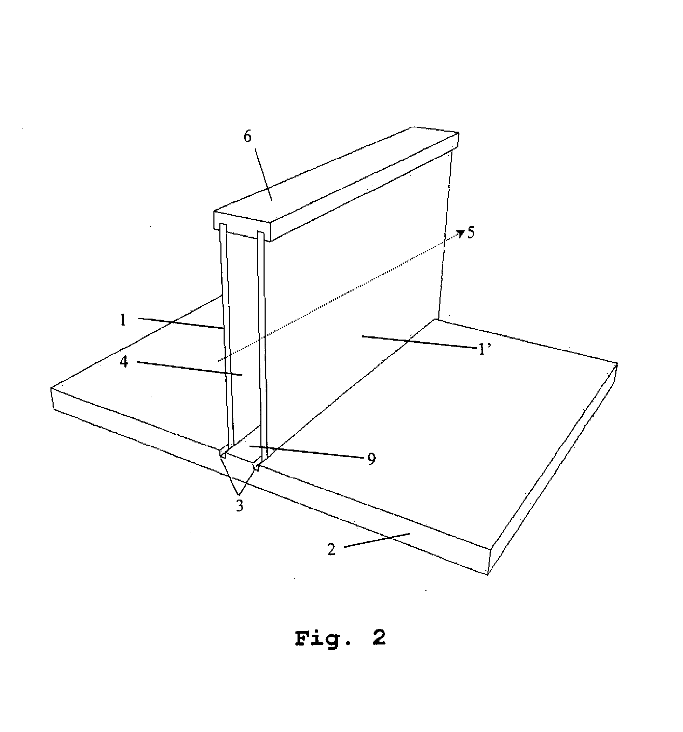

In Fig. 2 ist eine erfindungsgemäße Anordnung dargestellt, bei der die obere Schiene (in Fig. 1 dargestellt als 3) durch einen aufgesetzten Deckel 6 ersetzt wurde. Der Deckel 6 fährt mit den Substratträgern 1 und 1' durch die Beschichtungsanlage. Bei dieser Variante wird zwar ebenfalls an der Innenseite 9 eine parasitäre Beschichtung stattfinden, diese kann aber ex-situ leicht entfernt werden. Hierzu stehen mechanische sowie chemische Methoden zur Verfügung. Eventuelle Schleusen werden an die hier dargestellte umgedrehte U-Geometrie angepasst, so dass der nun bewegliche Deckel 6 mit eingedichtet wird.

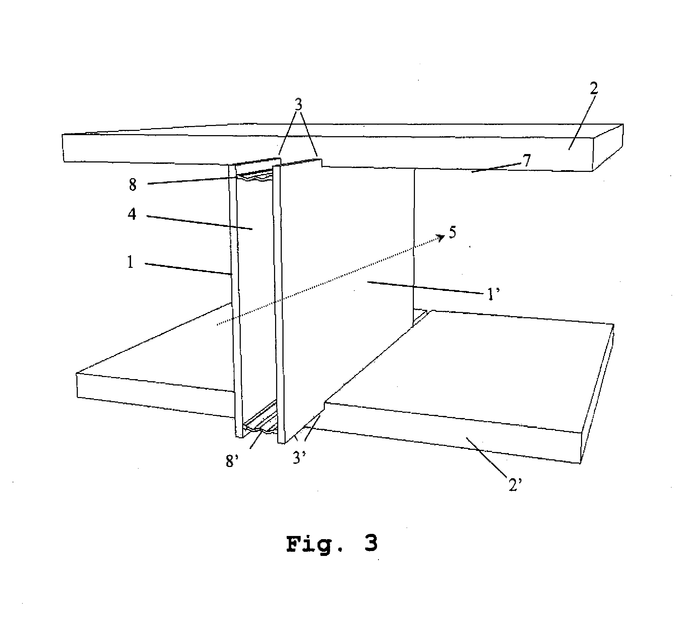

In Fig. 3 ist eine weitere erfindungsgemäße Vorrichtung dargestellt, bei der im Gegensatz zum Stand der Technik gemäß Fig. 1 im Bereich der oberen Schiene 3 und der unteren Schiene 3' jeweils in vertikaler Richtung bewegliche Schleiflappen 8 und 8' angeordnet sind, die die jeweiligen Schienen überdecken. In den Abscheidebereichen liegen diese Lappen 8 und 8' vor den jeweiligen Schienen und nehmen somit alle parasitären Abscheidungen auf. Anschließend werden die Lappen 8 und 8' mit den Substraten nach außen geführt, wo sie gereinigt oder entsorgt werden können. In Bereichen von Schleußen, Einlassdüsen, etc., die von unten vertikal in die Abscheidezone hineinragen, kann der Lappen durch eine geeignete Führung in die vertikale gedrückt werden, so dass er an allen Einbauten vorbei laufen kann.

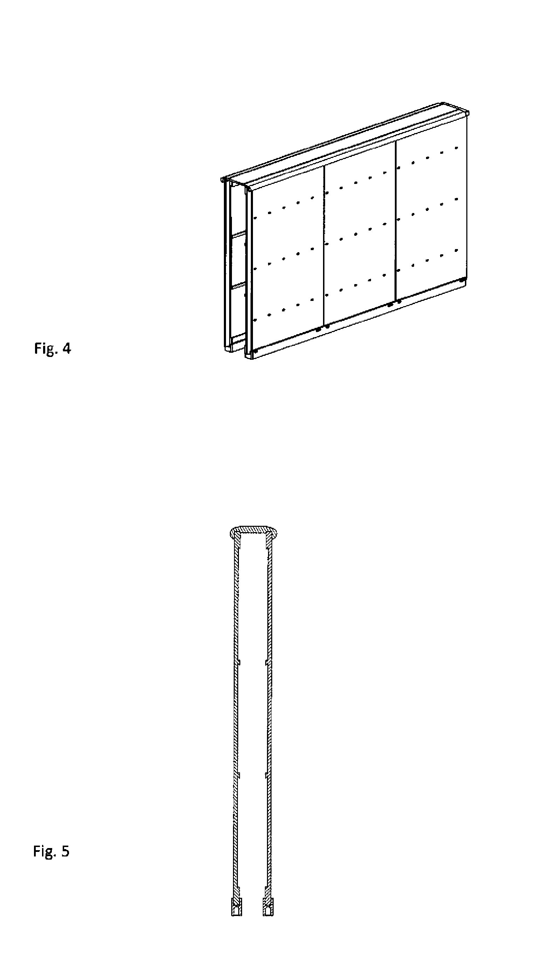

In Fig. 4 ist eine erfindungsgemäße Vorrichtung dargestellt, bei der die Substratträger 1 und 1' mit einem Deckel 6 fixiert sind. Diese Einheit aus Deckel und Substratträgern wird durch die Beschichtungsvorrichtung transportiert. Die Führungsschienen 3 sind an dem nicht dargestellten Boden 2 angeordnet. Auch hier können die Gasschleusen an die dargestellte umgekehrte U-Form angepasst werden, sodass der Deckel 6 mit abgedichtet wird.

In Fig. 5 ist eine Schnittdarstellung der Einheit aus Substratregeln 1 und 1' sowie dem Deckel 6 dargestellt. Hierauf ist erkennbar, dass der Deckel 6 kraftschlüssig mittels einer Klemmverbindung mit den Substratträgern 1 und 1' verbunden ist.

## Patentansprüche

1. Verfahren zur kontinuierlichen Beschichtung von Substraten, bei dem in einer Beschichtungsvorrichtung die Substrate durch einen Abscheideraum (4), der durch zwei Substratträger (1, 1') sowie einen Boden (2) und einen Deckel (6) begrenzt ist, wobei der Boden (2) eine Vorrichtung (3) zur Führung der Substratträger (1, 1') aufweist, die Substrate auf den Substratträgern (1, 1') durch die Beschichtungsvorrichtung transportiert werden, während des Transports die kontinuierliche Beschichtung der Substrate erfolgt und wobei der Deckel (6) an den Substratträgern (1, 1') fixiert ist und so zusammen mit den Substratträgern (1, 1') durch die Beschichtungsvorrichtung transportiert wird.

2. Verfahren nach Anspruch 1,
**dadurch gekennzeichnet, dass** vor dem Boden (2) im Abscheideraum (4) mindestens ein Abdeckelement (8) angeordnet wird.

3. Verfahren nach einem der vorhergehenden Ansprüche,
**dadurch gekennzeichnet, dass** als Abdeckelement (8) eine Opferschicht, insbesondere eine Kohlenstoffschicht, bevorzugt eine Rußschicht, oder eine Pulverschicht, bevorzugt aus Siliciumdioxid oder Siliciumnitrid auf dem Boden (2) abgeschieden ist und/oder als Abdeckelement (8) Lappen, Folien, Lamellen, Kämme, Dichtlippen oder O-Ringe verwendet werden.

4. Verfahren nach einem der vorhergehenden Ansprüche,
**dadurch gekennzeichnet, dass** die Beschichtungsvorrichtung eine Zone aufweist, in der der Deckel (6) und die Substratträger (1, 1') gereinigt oder zur Reinigung entnommen werden.

5. Verfahren nach einem der vorhergehenden Ansprüche,
**dadurch gekennzeichnet, dass** nach dem Transport aus dem Abscheideraum (4) heraus die parasitären Abscheidungen auf dem Deckel (6) entfernt werden.

6. Verfahren nach einem der vorhergehenden Ansprüche,
**dadurch gekennzeichnet, dass** in einer Rückätzzone, die vor, nach oder in dem Abscheideraum (4) angeordnet istvon mindestens einem der den Abscheideraum (4) begrenzenden Elemente (1, 1', 2, 6) und/oder mindestens eines der vor dem Boden (2) im Abscheideraum (4) angeordneten Abdeckelemente (8) mittels Ätzen die parasitären Abscheidungen entfernt werden.

7. Verfahren nach Anspruch 6,
**dadurch gekennzeichnet, dass** in der Rückätzzone durch mindestens eine Düse ein Ätzmittel geführt und auf mindestens eines der den Abscheideraum (4) begrenzenden Elemente (1, 1', 2, 6) und/oder mindestens eines der vor dem Boden (2) im Abscheideraum (4) angeordneten Abdeckelemente (8) zum Ätzen von parasitären Abscheidungen auf diesen Elementen gerichtet wird.

8. Vorrichtung zur kontinuierlichen Beschichtung von Substraten mit einem für die Gasphasenabscheidung vorgesehenen Abscheideraum (4), der durch zwei Substratträger (1, 1') sowie einen Boden (2) und einen Deckel (6) begrenzt ist, wobei der Boden (2) eine Vorrichtung (3) zur Führung der Substratträger (1, 1') aufweist und wobei der Deckel (6) an den Substratträgern (1, 1') fixiert ist und so zusammen mit den Substratträgern (1, 1') durch die Beschichtungsvorrichtung transportabel ist, dass der Deckel (6) und die Substratträger (1,1') zusammen mit dem Substrat aus dem Abscheideraum (4) heraus transportiert werden können.

9. Vorrichtung nach dem vorhergehenden Anspruch,
**dadurch gekennzeichnet, dass** die Vorrichtung eine Zone aufweist, in der der Deckel (6) und die Substratträger (1, 1') gereinigt oder zur Reinigung entnommen werden können.

10. Vorrichtung nach einem der Ansprüche 8 oder 9,
**dadurch gekennzeichnet, dass** vor dem Boden (2) im Abscheideraum (4) mindestens ein Abdeckelement (8) angeordnet ist.

11. Vorrichtung nach einem der Ansprüche 8 bis 10,
**dadurch gekennzeichnet, dass** das Abdeckelement (8) eine Opferschicht ist und/oder das Abdeckelement (8) ausgewählt ist aus der Gruppe bestehend aus Lappen, Folien, Lamellen, Kämmen, Dichtlippen oder O-Ringen oder Kombinationen hiervon, insbesondere eine Kohlenstoffschicht, bevorzugt eine Rußschicht, oder eine Pulverschicht, bevorzugt aus Siliciumdioxid oder Siliciumnitrid.

12. Vorrichtung nach einem der Ansprüche 8 bis 11,
**dadurch gekennzeichnet, dass** die Vorrichtung eine Rückätzzone aufweist, die vor, nach oder in dem Abscheideraum (4) angeordnet ist.

13. Vorrichtung nach Anspruch 12,
**dadurch gekennzeichnet, dass** in der Rückätzzone mindestens eine Düse für ein Ätzmittel angeordnet ist, wobei die Düse auf mindestens eines der den Abscheideraum (4) begrenzenden Elemente (1, 1', 2, 6) und/oder mindestens eines der vor dem Boden (2) im Abscheideraum (4) angeordneten Abdeckelemente (8) zum Ätzen von parasitären Abscheidungen auf diesen Elementen gerichtet ist.

14. Vorrichtung nach einem der Ansprüche 8 bis 13,
**dadurch gekennzeichnet, dass** die Vorrichtung (3) zur Führung der Substratträger (1, 1') mindestens eine Schiene ist.

## Claims

1. Method for continuous coating of substrates in which, in a coating device, the substrates are transported through a deposition chamber (4) which is delimited by two substrate carriers (1, 1') and also a base (2) and a cover (6), the base (2) having a device (3) for guiding the substrate carriers (1, 1'), the substrates on the substrate carriers (1, 1') being transported through the coating device, the continuous coating of the substrates being effected during the transport and the cover (6) being fixed to the substrate carriers (1, 1') and thus being transported together with the substrate carriers (1, 1') through the coating device.

2. Method according to claim 1,
**characterised in that** at least one cover element (8) is disposed in front of the base (2) in the deposition chamber (4).

3. Method according to one of the preceding claims,
**characterised in that** a sacrificial layer, in particular a carbon layer, preferably a carbon black layer, preferably made of silicon dioxide or silicon nitride, as cover element (8), is deposited on the base (2) and/or cloths, foils, lamellae, combs, sealing lips or O-rings are used as cover element (8).

4. Method according to one of the preceding claims,
**characterised in that** the coating device has a zone in which the cover (6) and the substrate carriers (1, 1') are cleaned or removed for cleaning.

5. Method according to one of the preceding claims,
**characterised in that**, after transport out of the deposition chamber (4), the parasitic deposits on the cover (6) are removed.

6. Method according to one of the preceding claims,
**characterised in that**, in an etching-back zone, which is disposed in front of, after or in the deposition chamber (4), the parasitic deposits are removed by means of etching from at least one of the elements (1, 1', 2, 6) which delimit the deposition chamber (4) and/or from at least one of the cover elements (8) which are disposed in front of the base (2) in the deposition chamber (4).

7. Method according to claim 6,
**characterised in that**, in the etching-back zone, an etching means is guided through at least one nozzle and is directed towards at least one of the elements (1, 1', 2, 6) which delimit the deposition chamber (4) and/or towards at least one of the cover elements (8) which are disposed in front of the base (2) in the deposition chamber (4) for etching of parasitic deposits on these elements.

8. Device for continuous coating of substrates having a deposition chamber (4) which is provided for the chemical vapour deposition and is delimited by two substrate carriers (1, 1') and also a base (2) and a cover (6), the base (2) having a device (3) for guiding the substrate carriers (1, 1'), and the cover (6) being fixed to the substrate carriers (1, 1') and thus being able to be transported together with the substrate carriers (1, 1') through the coating device, in that the cover (6) and the substrate carriers (1, 1') together with the substrate can be transported out of the deposition chamber (4).

9. Device according to the preceding claim,
**characterised in that** the device has a zone in which the cover (6) and the substrate carriers (1, 1') can be cleaned or removed for cleaning.

10. Device according to one of the claims 8 or 9,
**characterised in that** at least one cover element (8) is disposed in front of the base (2) in the deposition chamber (4).

11. Device according to one of the claims 8 to 10,
**characterised in that** the cover element (8) is a sacrificial layer and/or the cover element (8) is selected from the group consisting of cloths, foils, lamellae, combs, sealing lips or O-rings and combinations hereof, in particular a carbon layer, preferably a carbon black layer, or a powder layer, preferably made of silicon dioxide or silicon nitride.

12. Device according to one of the claims 8 to 11,
**characterised in that** the device has an etching-back zone which is disposed in front of, after or in the deposition chamber (4).

13. Device according to claim 12,
**characterised in that**, in the etching-back zone, at least one nozzle for an etching agent is disposed, the nozzle being directed towards at least one of the elements (1, 1', 2, 6) which delimit the deposition chamber (4) and/or towards at least one of the cover elements (8) which are disposed in front of the base (2) in the deposition chamber (4) for etching of parasitic deposits on these elements.

14. Device according to one of the claims 8 to 13,
**characterised in that** the device (3) for guiding the substrate carriers (1, 1') is at least one rail.

## Revendications

1. Procédé permettant le revêtement en continu de substrats, dans lequel, dans un dispositif de revêtement, les substrats sont constitués d'un espace de déposition (4), qui est limité par deux supports de substrats (1, 1') ainsi que par un fond (2) et par un couvercle (6), le fond (2) comprenant un dispositif (3) pour le guidage des supports de substrats (1, 1'), les substrats sont transportés sur les supports de substrats (1, 1') par le dispositif de revêtement, pendant le transport le revêtement en continu des substrats a lieu et le couvercle (6) est fixé aux supports de substrats (1, 1') et transporté ainsi avec les supports de substrats (1, 1') par le dispositif de revêtement.

2. Procédé selon la revendication 1,
**caractérisé en ce que**, avant le fond (2), dans l'espace de déposition (4), se trouve au moins un élément de recouvrement (8).

3. Procédé selon l'une des revendications précédentes,
**caractérisé en ce que**, en tant qu'élément de recouvrement (8), une couche sacrificielle, plus particulièrement une couche de carbone, de préférence une couche de suie ou une couche pulvérulente, de préférence en dioxyde de silicium ou en nitrure de silicium, est déposée sur le fond (2) et/ou, en tant qu'élément de recouvrement (8), des bandes, des films, des lamelles, des peignes, des lèvres d'étanchéité ou des joints toriques sont utilisés.

4. Procédé selon l'une des revendications précédentes,
**caractérisé en ce que** le dispositif de revêtement comprend une zone dans laquelle le couvercle (6) et les supports de substrats (1, 1') sont nettoyés ou retirés pour le nettoyage.

5. Procédé selon l'une des revendications précédentes,
**caractérisé en ce que**, après le transport hors de l'espace de déposition (4), les dépôts parasites sur le couvercle (6) sont éliminés.

6. Procédé selon l'une des revendications précédentes,
**caractérisé en ce que**, dans une zone de rétro-décapage, agencée avant, après ou dans l'espace de déposition, des dépôts parasites sont retirés par décapage sur au moins un des éléments (1, 1', 2, 6) limitant l'espace de déposition (4) et/ou au moins un des éléments de recouvrement (8) disposés avant le fond (2) dans l'espace de déposition (4).

7. Procédé selon la revendication 6,
**caractérisé en ce que**, dans la zone de rétro-décapage, au moins une buse permet de guider un produit de décapage et est dirigée vers au moins un des éléments (1, 1', 2, 6) limitant l'espace de déposition (4) et/ou au moins un des éléments de recouvrement (8) disposés avant le fond (2) dans l'espace de déposition (4) pour le décapage de dépôts parasites sur ces éléments.

8. Dispositif de revêtement en continu de substrats avec un espace de déposition (4) conçu pour un dépôt en phase gazeuse, qui est limité par deux supports de substrats (1, 1') ainsi que par un fond (2) et un couvercle (6), le fond (2) comprenant un dispositif (3) pour le guidage des supports de substrats (1, 1') et le couvercle (6) étant fixé aux supports de substrats (1, 1') et pouvant ainsi être transporté avec les supports de substrats (1, 1') par le dispositif de revêtement, de façon à ce que le couvercle (6) et les supports de substrats (1, 1') peuvent être transportés avec le substrat hors de l'espace de déposition (4).

9. Dispositif selon la revendication précédente,
**caractérisé en ce que** le dispositif comprend une zone dans laquelle le couvercle (6) et les supports de substrats (1, 1') peuvent être nettoyés ou retirés pour le nettoyage.

10. Dispositif selon l'une des revendications 8 ou 9,
**caractérisé en ce que**, avant le fond (2), dans l'espace de déposition (4), se trouve au moins un élément de recouvrement (8).

11. Dispositif selon l'une des revendications 8 à 10,
**caractérisé en ce que** l'élément de recouvrement (8) est une couche sacrificielle et/ou l'élément de recouvrement (8) est sélectionné dans le groupe constitué de bandes, des films, de lamelles, de peignes, de lèvres d'étanchéité ou de joints toriques ou de combinaisons de ceux-ci, plus particulièrement une couche de carbone, de préférence une couche de suie ou une couche pulvérulente, de préférence en dioxyde de silicium ou en nitrure de silicium.

12. Dispositif selon l'une des revendications 8 à 11,
**caractérisé en ce que** le dispositif comprend une zone de rétro-décapage qui est disposée avant, après ou dans l'espace de déposition (4).

13. Dispositif selon la revendication 12,
**caractérisé en ce que**, dans la zone de rétro-décapage, se trouve au moins une buse pour un produit de décapage, la buse étant dirigée vers au moins un des éléments (1, 1', 2, 6) limitant l'espace de déposition (4) et/ou au moins un des éléments de recouvrement (8) disposés avant le fond (2) dans l'espace de déposition (4) pour le décapage des dépôts parasites sur ces éléments.

14. Dispositif selon l'une des revendications 8 à 13,
**caractérisé en ce que** le dispositif (3) de guidage des supports de substrats (1, 1') est au moins un rail.
